(19) Europäisches Patentamt
European Patent Office
Office européen des brevets

(11) **EP 1 903 610 A2**

(12) **EUROPÄISCHE PATENTANMELDUNG**

(43) Veröffentlichungstag:
26.03.2008 Patentblatt 2008/13

(51) Int Cl.:
*H01L 27/32* (2006.01)

(21) Anmeldenummer: 07018549.1

(22) Anmeldetag: **21.09.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **21.09.2006 DE 102006045070**

(71) Anmelder:
• **OPTREX EUROPE GmbH**
**64832 Babenhausen (DE)**
• **Fraunhofer-Gesellschaft zur Förderung der angewandten Forschung e.V.**
**80686 München (DE)**

(72) Erfinder:
• **Wahl, Jürgen, Dr.**
**65812 Bad Soden (DE)**
• **Barth, Siegfried, Dr.**
**35037 Marburg/Lahn (DE)**
• **Hoffmann, Michael**
**01187 Dresden (DE)**
• **Amelung, Jürgen**
**01099 Dresden (DE)**

(74) Vertreter: **KEIL & SCHAAFHAUSEN**
**Patentanwälte**
**Cronstettenstrasse 66**
**60322 Frankfurt am Main (DE)**

(54) **OLED-Anzeige**

(57) Es wird ein Aufbau für eine transparente OLED-Anzeige mit transparenten Ansteuerelektroden (Anoden 10, Kathoden 50) mit vorzugsweise selektiver und teilselektiver Emissionsrichtung beschrieben. Zwischen den Elektroden 10, 50 befinden sich eine oder mehrere Schichten 20, 30, 40, von denen mindestens eine eine organische Emissionsschicht 30 ist. Diese Schichten sind auf einem transparenten Substrat 2 angeordnet. Für die Ansteuerung einer derartigen Anzeige sind die Anoden 10 sehr niederohmig ausgeführt, so dass diese bei einer Ansteuerung im Multiplexbetrieb als Scanelektrode dienen können. Die Kathoden 50 sind dagegen als Datensignale erhaltende Gegenelektroden ausgeführt.

Fig. 1

EP 1 903 610 A2

**Beschreibung**

Die Erfindung betrifft eine OLED-Anzeige mit oberen und unteren Elektroden, zwischen denen eine oder mehrere Schichten angeordnet sind, von denen mindestens eine eine organische Emissionsschicht (30) ist, und mit einem transparenten Substrat. Beispielsweise kann die OLED-Anzeige als OLED-Matrixanzeige ausgebildet mit Zeilen- und Spaltenelektroden ausgebildet sein. Im nachfolgenden wird häufig auf den Aufbau einer Matrixanzeige Bezug genommen, ohne dass die Erfindung hierauf beschränkt ist. So lässt sich die Erfindung auch bei Mehr-Segmentanzeigen, bspw. 7-Segment-Anzeigen, oder dgl. anwenden.

Der Aufbau einer OLED-Anzeige ist typischerweise derart, dass auf dem transparenten Substrat, das beispielsweise aus Glas oder einer transparenten Folie bestehen kann, eine transparente Anodenschicht aufgebracht wird, die beispielsweise aus einer transparenten Oxidschicht wie Indium-Zink-Oxid (ITO) oder Zinn-Oxid besteht, und als Elektrode dient. Auf dieser Schicht wird das Emittersystem aufgebracht, das eine organische Emissionsschicht und typischerweise diese umgebende organische und/oder anorganische Hilfsschichten insbesondere als Löchertransportschicht und Elektrodentransportlefter aufweist. Hierauf wird eine weitere Elektrodenschicht als Kathode aufgebracht.

Bei einer konventionellen Elektrodenanordnung nicht-transparenter OLED-Anzeigen werden die darzustellenden Signale in Abhängigkeit von der gerade angesteuerten Zeile auf die Spalten aufgeprägt, die als transparente Anoden ausgebildet sind. Diese Spalten können leicht als transparente Elektrodenschicht ausgebildet werden, da in jeder dieser Spalten nur ein geringer Strom fließt. Der Strom aller Spalten wird dann in der jeweils angesteuerten Zeile gesammelt und fließt als Gesamtstrom über die jeweilige Zeilenelektrode (Kathode) ab. Dieser Vorgang wird auch als Scannen oder Multiplexen bezeichnet.

Aufgrund des im Vergleich zu den Anoden auf dem Substrat hohen Stromfluss in dem als Deckelektrode der OLED-Anzeige dienenden Kathoden ist es notwendig, diese niederohmig an eine Treibersteuerung anzuschließen. Daher werden diese Kathoden häufig als metallische Kathoden ausgebildet, so dass diese keine oder eine vergleichsweise schlechte Transparenz aufweisen.

Bei diesem Aufbau ergeben sich daher Schwierigkeiten, wenn die OLED-Anzeige als transparentes Display ausgebildet werden soll.

Aufgabe der vorliegenden Erfindung ist es daher, eine verbesserte transparente OLED-Anzeige vorzuschlagen, bei welcher vorzugsweise auch eine bevorzugte Emissionsrichtung des Lichtes ausgewählt werden kann.

Diese Aufgabe wird mit den Merkmalen des Patentanspruchs 1 gelöst. Dabei ist vorgesehen, dass in Umkehrung der im Stand der Technik üblichen Ansteuerung der OLED-Anzeige die gescannten Elektroden bei Multiplexansteuerung als Anode ausgeführt sind und aus einem transparenten Material bestehen und dass die Datensignale erhaltenden Gegenelektroden als transparente Kathoden ausgeführt sind. Die auf dem Substrat selbst angebrachten Elektroden (Anode) können, auch wenn sie aus einem transparenten Material beispielsweise in Form einer transparenten Oxidschicht wie ITO, AZO oder IZO bestehen, sehr niederohmig gestaltet werden. Dadurch ist es möglich, diese Anoden mit einem höheren Strom zu beaufschlagen, so dass sie besonders vorteilhaft als gescannte Elektroden (typischerweise Zeilenelektrode), eingesetzt werden können. Die meist als Deckelektrode ausgebildeten transparenten Kathoden müssen dann nur noch einen niedrigeren Stromfluss bewältigen und können als transparente Metall- bzw. Oxidschichten ausgebildet werden. Der Anschluss ist dann höherohmig als bei Kathoden im nicht-transparenten, konventionellen Aufbau einer OLED-Anzeige, da auch die benötigten Metallschichten vergleichsweise dünn ausgebildet werden können und daher eine bessere Transparenz besitzen, Bevorzugt sind jedoch transparente Oxidschichten wie ITO, AZO oder IZO für die Kathode, ggf. in Verbindung mit geeigneten Hilfsschichten.

In einer besonders bevorzugten Ausführungsform der OLED-Anzeige sind die Elektroden der Anode mit einer niederohmigen Begleitbahn versehen, die vorzugsweise wesentlich schmäler ausgebildet ist als die die Pixelbreite bestimmende Breite der Zeilen- bzw. Spaltenelektrode, wobei die niederohmige Begleitbahn mit der transparenten Elektrode bzw. Elektrodenschicht leitend verbunden ist. Auf diese Weise kann der aus den Gegenelektroden aufgenommene Strom besonders niederohmig und damit mit geringer Wärmeentwicklung in der Anode abgeführt werden.

Dazu kann die niederohmige Begleitbahn einer jeden Zeilen- bzw. Spaltenelektrode aus einer dünnen Metallschicht bestehen, die zwar nur eine geringe oder keine Transparenz aufweist, jedoch aufgrund ihrer geringen Breite im Vergleich zu der Gesamtbreite der Zeilen- bzw. Spaltenelektrode optisch kaum auffällt.

Als besonders vorteilhaftes Material kann für die Metallschicht Kupfer gewählt werden. Als weitere metallische Materialien für die Begleitbahnen kommen auch Nickel, Aluminium, Silber, Messing in Frage. Die Breite dieser niederohmigen, metallischen Begleitbahnen sind vorzugsweise kleiner als etwa 1/10 der Zeilenbreite, wobei die Dicke vorzugsweise kleiner als 1,2 $\mu$m beträgt.

Die als Zeilen- oder Spaltenelektroden ausgebildeten Elektroden der transparenten Kathode können aus einer oder mehreren dünnen Metallschicht(en) aufgebaut sein, wobei die Metallschicht eine geringe Elektrodenaustrittsarbeit aufweisen soll. Geeignete Materialien sind beispielsweise Silber, Aluminium, Ytterbium oder dergleichen, das vorzugsweise in einer Dicke zwischen 10 bis 30 nm aufgebracht ist. In dieser sehr dünnen Schicht ist die Metallschicht optisch relativ transparent.

Alternativ können die Spalten- bzw. Zeilenelektroden der transparenten Kathode aus einem transparenten anorganischen bzw, halbleitenden Material zusammen mit einer organischen oder anorganischen, n-dotierten Hilfsschicht aufgebaut sein. Hierfür kommt insbesondere eine Schicht aus ITO, IZO, AZO in Verbindung mit einer transparenten organischen Hilfsschicht in Betracht.

Bei der erfindungsgemäßen OLED-Anzeige können vorzugsweise auf jeder der beiden Seiten der organischen Emissionsschicht mindestens eine organische und/oder anorganische Hilfsschicht vorgesehen sein, die beispielsweise mit den Elektrodenschichten zusammenwirkt.

Ferner können auf einer dem transparenten Substrat gegenüberliegenden Seite der OLED-Anzeige angeordneten Elektrode, welche auch als Deckelelektrode bezeichnet wird, ein eine oder mehrere Hilfsschicht (en) aufweisendes Auskoppelsystem vorgesehen sein. Auch diese Hilfsschichten können als organische und/oder anorganische Schichten ausgebildet sein.

Da die OLED-Anzeige mit ihrem OLED-System einen optischen Resonator darstellt, kann dieser innerhalb der Anzeige zur Lichtsteuerung verwendet werden. Dazu ist vorgesehen, dass mindestens eine Hilfsschicht bezüglich ihrer Dicke und/oder ihres Brechungsindex derart ausgewählt wird, dass die Emission des Lichtes der OLED-Anzeige teilweise oder vollständig nur zur einer Seite der OLED-Anzeige hin erfolgt. Dazu können die einzelnen Schichten durch Optimierung der Brechungsindices (teilweise mit Imaginärteil) und/oder der Schichtdicken auch so abgestimmt werden, dass die Lichtaussendung vorzugsweise in eine Richtung konzentriert wird, wobei eine Lichtemission durch das transparente Substrat auch als Bottom-Emisslon und die Emission durch die dem Substrat gegenüberliegende Elektrode (Deckelelektrode, Kathode) auch als Top-Emission bezeichnet wird. Die Steuerung interner Reflexionen ist dabei richtungsabhängig.

Ferner kann auf einer dem transparenten Substrat gegenüberliegenden Seite der OLED-Anzeige angeordneten Elektrode (Deckelelektrode) ein eine oder mehrere Hilfsschicht(en) aufweisendes Auskoppelsystem vorgesehen sein, das ebenso zur Selektion der Emissionsrichtung verwendet werden kann.

In diesem Fall kann die Hilfsschicht bzw. können die Hilfsschichten des Auskoppelsystems und/oder des die Hilfsschichten sowie ggf, die organische Emissionsschicht und die Elektrodenschichten einschließenen OLED-Stapels als wellenlängenselektiver dielektrischer Spiegel ausgebildet sein, vorzugsweise als schmalbandiger Hoch-Reflektor. Ein derartiger dielektrischer Spiegel arbeitet als sogenannter distributed Bragg reflector (DBR).

Dieser vorbeschriebene Aspekt der richtungsselektiven Emission aus einer transparenten OLED-Anzeige stellt prinzipiell einen eigenständigen Aspekt der vorliegenden Erfindung dar, der auch ohne die vorteilhafte Konfiguration der Anode als gescannte Elektrode und der Kathode als Datensignale erhaltende Gegenelektrode Anwendung finden kann.

Um eine geringe Erwärmung der OLED-Anzeige zu erreichen bzw. insgesamt eine verlustarme Beschaltung der OLED-Anzeige vorzuschlagen, kann vorzugsweise eine niederohmige Schaltung auf dem transparenten Substrat der OLED-Anzeige zur direkten Kontaktierung eines oder mehrerer Treiber(s) durch anisotrope Kontaktmedien sowie zur niederohmigen Anbindung der Zeilen- und Spaltenelektroden vorgesehen sein.

In diesem Zusammenhang ist es besonders vorteilhaft, wenn ein Treiberbaustein mit einer Funktion zum Scannen von Anoden unter hoher Strombelastung und zur Lieferung von Datensignale für die Kathode vorgesehen ist, wobei der Treiber entsprechend der erfindungsgemäßen Konfiguration der Elektroden organisiert ist.

Gemäß einem weiteren Aspekt der vorliegenden Erfindung kann die vorbeschriebene OLED-Anzeige als transparentes Display im Sinne eines zusätzlichen Displays auf mindestens einem anderen Display angeordnet sein, welches auch eine der vorbeschriebenen, erfindungsgemäßen OLED-Anzeigen sein kann oder ein Display beliebiger Technologie. Dies ermöglicht die Realisierung einer vorgelagerten, transparenten Informationsebene und/oder die Erzielung eines 3-dimensionalen Bildeffektes, so dass die vorgeschlagene transparente OLED-Anzeige hierfür besonders vorteilhaft verwendet werden kann.

Die Erfindung wird nachfolgend unter Bezugnahme auf die Zeichnung erläutert. Dabei bilden alle beschriebenen und/oder bildlich dargestellten Merkmale für sich oder in beliebiger Kombination den Gegenstand der Erfindung, unabhängig von ihrer Zusammenfassung in den Ansprüchen oder deren Rückbeziehung.

Es zeigen:

Fig. 1      einen Querschnitt durch eine erfindungsgemäße OLED-Anzeige gemäß einer ersten Ausführungsform;

Fig. 2      schematisch eine Schaltungsanordnung der Zeilen- und Spaltenelektroden einer OLED-Anzeige nach dem Stand der Technik;

Fig. 3      schematisch eine Schaltungsanordnung der Zeilen- und Spaltenelektroden der erfindungsgemäßen OLED-Anzeige gemäß Fig. 1;

Fig. 4      die Schaltungsanordnung gemäß Fig. 3 mit einer Treiberschaltung;

Fig. 5      eine auf einem weiteren Display vorgesehene erfindungsgemäße OLED-Anzeige;

Fig. 6      einen Querschnitt durch eine erfindungsgemäße OLED-Anzeige gemäß einer zweiten Ausführungsform;

Fig. 7    einen Querschnitt durch eine erfindungsgemäße OLED-Anzeige gemäß einer dritten Ausführungsform;

Fig. 8    ein Diagramm zur Emissionsverhältnisänderung durch Variation der Dicke der Hilfsschicht Elektronentransportleiter;

Fig. 9    ein Diagramm zur Emissionsverhältnisänderung durch Variation der Dicke der Hilfsschicht Löchertransportschicht;

Fig. 10    ein Diagramm zur Emissionsverhältnisänderung durch Variation der Dicke der Hilfsschicht Auskoppelschicht;

Fig. 11    die berechnete spektrale Transmission einer erfindungsgemäßen OLED-Anzeige im Vergleich zu einer bekannten OLED-Anzeige und

Fig. 12    die berechnete spektrale Emission einer erfindungsgemäßen OLED-Anzeige im Vergleich zu einer bekannte OLED-Anzeige.

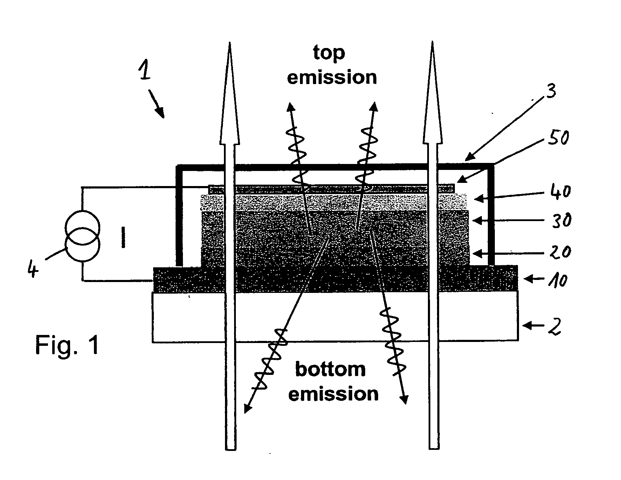

Fig. 1 zeigt den Querschnitt einer typischen OLED-Struktur einer OLED-Anzeige 1, die auf einem transparenten Substrat 2 angeordnet ist. Auf das Substrat 2 ist zunächst eine als Zeilenelektrode ausgebildete Elektrodenschicht 10 aufgebracht, die als Anode dient und im Wesentlichen eine transparente Oxidschicht (bspw. ITO) aufweist. Auf der Elektrodenschicht 10 ist dann eine organische Hilfsschicht 20 angeordnet, beispielsweise eine Löchertransportschicht. Diese wiederum trägt die organische Emissionsschicht 30, auf der eine weitere, beispielsweise als Elektronentransportleker dienende organische Hilfsschicht 40 aufgebracht ist. Die beiden Hilfsschichten 20, 40 und die eigentliche organische Emissionsschicht 30 bilden auch den sog, OLED-Stapel 31. Auf der zweiten organischen Hilfsschicht 40 ist ein zweite Elektrodenschicht 50 angeordnet, die als Kathode und Gegenelektrode dient und auch als Dekkelelektrode bezeichnet wird. Im Falle einer Zeilenelektrode 10 ist die Gegenelektrode als Spaltenelektrode 50 ausgebildet, wobei die Aufteilung in Zeilen und Spalten auch gerade umgekehrt erfolgen kann. Der OLED-Stapel 31 und die Kathode 50 sind durch eine transparente Einkapselung 3 ummantelt. Die Elektrodenschichten 10, 50 sind an eine Stromquelle 4 angeschlossen.

Im Rahmen der Erfindung besteht die Kathode 50 im Wesentlichen aus einer sehr dünnen und damit optisch relativ transparenten Metallschicht mit geringer Elektronenaustrittsarbeit (z.B. Ag, Al, Yb,.. , Dicke vorzugsweise 10 bis 30nm) oder bevorzugt aus einer transparenten Schicht aus ITO, IZO, AZO ..., in Verbindung mit einer angrenzenden n-dotierten, ebenfalls transparenten organischen Hilfsschicht 40, die als Elektronentransportleiter dient. Die einzelnen Schichten, insbesondere die organischen Hilfsschichten 20, 40, können durch Optimierung der Brechungsindices (teilweise mit Imaginäranteil) und der Schichtdicken so abgestimmt wer den, dass die Lichtaussendung vorzugsweise in eine Richtung konzentriert wird (Top- oder Bottom-Emission), wobei als Top-Emission eine Lichtemission durch die insofern auch als Deckelelektrode bezeichnete Elektrode 50 und als Bottom-Emission eine Lichtemission durch das transparente Substrat 2 bezeichnet wird. Durch die Ausbildung der Kathode 50 als transparente Elektrodenschicht ist die gesamte OLED-Anzeige 1 transparent. Beispielhaft ist die Blickrichtung auf das Substrat 2 durch die beiden großen Pfeile dargestellt.

Der Schichtaufbau der OLED-Anzeige 1 kann auch umgekehrt auf dem Substrat 2 angeordnet sein, d.h. die Kathode 50 befindet sich auf dem Substrat und die Anode 10 bildet die Deckelelektrode, wie dies für eine andere Ausführungsform in Fig. 7 dargestellt ist.

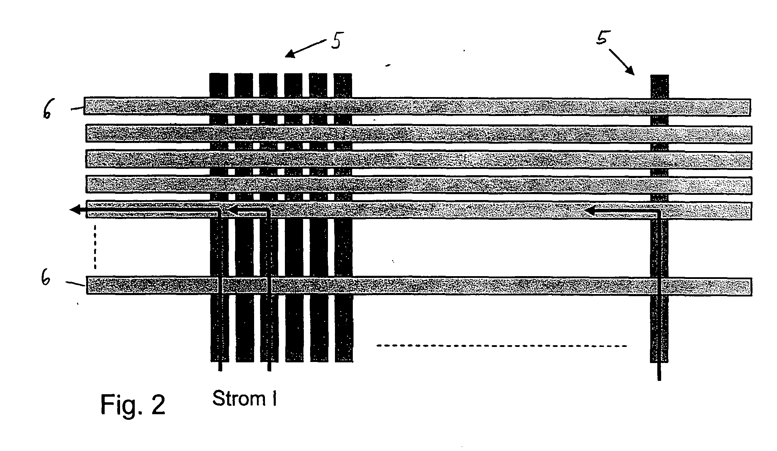

Fig. 2 zeigt in einer Sicht von oben (vlg. Fig. 1) eine konventionelle ElektrodenAnordnung einer nichttransparenten OLED-Anzeige. Die transparente Anoden ist als Spaltenelektroden 5 auf dem nicht dargestellten Substrat der OLED-Anzeige angeordnet. Die Kathode ist aus Zeilenelektroden 6 aufgebaut, die sehr niederohmig, meist mit einer vergleichsweise dicken Metallschicht, und daher nicht transparent sind. Über die im Muttiplexbetrieb selektierte Kathoden-Elektrode (Zeilenelektrode 6) fließt der Strom aller Anoden (Spaltenelektroden 5) ab, d.h. die Zeilen werden gescannt. Der Strom in einer Zeilenelektrode bzw. -kathode 6 enthält die darzustellenden Datensignale. Der Stromfluss ist durch die Pfeile auf den Spaltenelektroden 5 und der einen selektierten Zeilenelektrode 6 verdeutlicht.

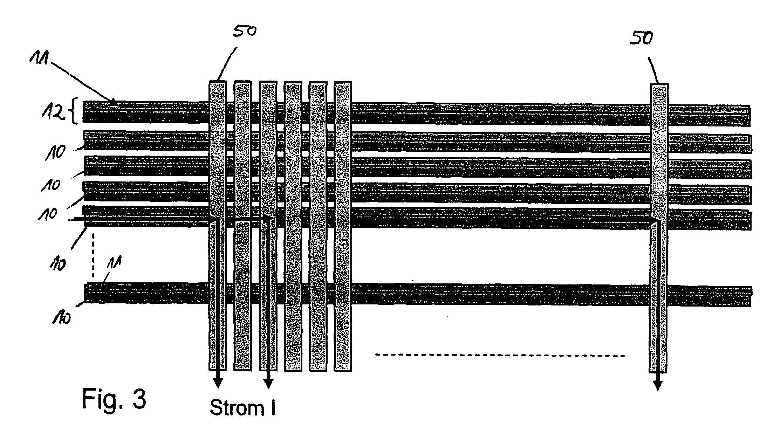

Fig. 3 zeigt die Elektrodenanordnung einer erfindungsgemäßen transparenten OLED-Matrixanzeige 1 mit gegenüber Fig. 2 vertauschten Anoden- und Kathodenrichtungen. In dieser Anordnung werden die Spalten durch die Kathode 50 gebildet. Diese sind vergleichsweise dünn ausgebildet und weisen eine im Vergleich zu den herkömmlichen Zeilenkathoden relativ hohe Transparenz auf, so dass die OLED-Anzeige 1 insgesamt transparent ist. Allerdings sind die Kathoden 50 höherohmig als bei dem nicht transparenten, konventionellen Aufbau, wie er zuvor mit Bezug auf Fig. 3 beschrieben wurde. Daher sind diese Kathoden 50 nicht mehr zum Scannen geeignet. Den Kathoden 50 werden daher die Datensignale zugeführt. Gescannt werden die Anoden 10, die unmittelbar auf dem Substrat angeordnet sind und einfach einen niederohmigen Anschluss ermöglichen. Um den in den einzelnen Kathodenspalten 50 zugeführten Strom besonders niederohmig abführen zu können, sind die gescannten Anodenzeilen 10 zusätzlich mit einer metallischen Begleitbahn 11 zur Reduzierung des Widerstandes der langen Anoden-Linien 12 versehen. Das Display kann natürlich statt horizontal wie in der Fig. 3 auch vertikal orientiert sein, was zu einer Vertauschung der Begriffe Zeilen und Spalten führt.

Diese metallischen Begleitbahnen 11 können bspw. aus Ni, Al, Ag, Cu, Ms, oder dgl. ausgebildet sein, deren Breite wesentlich kleiner ist als die Zeilenbreite der OLED-Anzeige 1, die mit der Breite der Anoden-Linie 10 korreliert. Vorzugsweise beträgt die Breite weniger als 1/10 der Zeilenbreite. Die Dicke der Begleitbahnen 11 liegt vorzugsweise unter 1,2 $\mu$m. Bei gut leitenden Materialien kann ggf. auch eine Dicke der Begleitbahn von etwa 0,5 $\mu$m gewählt werden. Diese Begleitbahnen 11 fallen daher in der Durchsicht durch das Display kaum auf und mindern dessen Transparenz nicht merklich. Der Stromfluss ist in Fig. 3 durch auf den Anoden 10 und Kathoden 50 verlaufende Pfeile dargestellt.

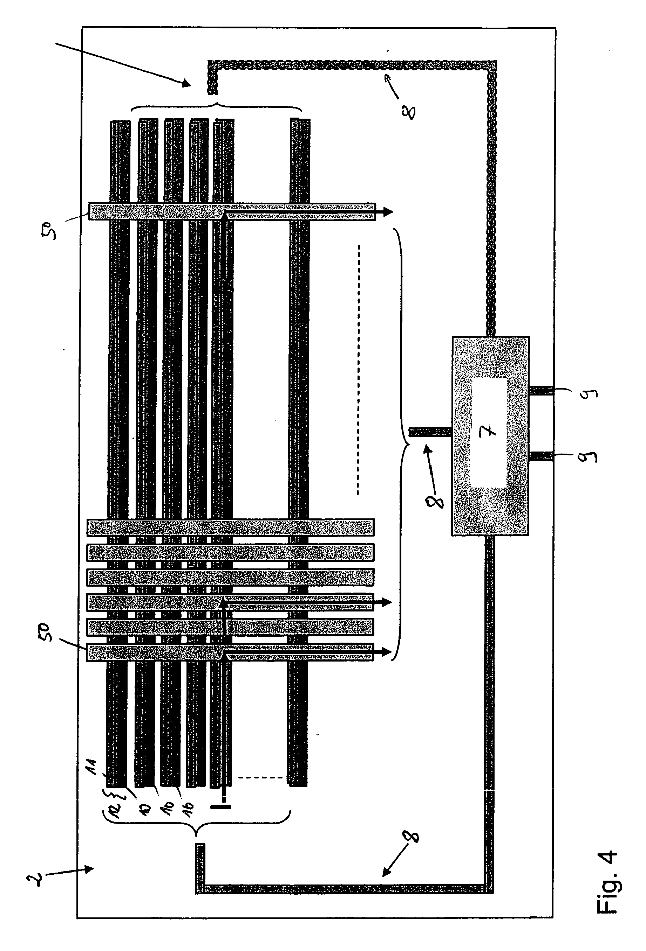

Fig. 4 zeigt die Schaltanordnung gemäß Fig. 3 mit auf dem transparenten, bspw. als Glas oder Folie ausgebildeten Substrat 2 integriertem Treiber 7 (oder auch mehrerer Treiber) samt niederohmiger metallischer oder metallisierter Zuleitungen 8 zu den Zeilen- und Spaltenelektroden 10, 50 der OLED-Anzeige 1. Die Zuleitungen 8 können einseitig, zweiseitig oder zeilenweise alternierend (rechts/links bzw. oben/unten) ausgeführt sein. Die Spaltenausgänge des Treibers 7 versorgen in dieser Anordnung die Kathoden 50 mit Datensignalen, wobei der Treiber 7 die Anoden 10 scannt. Die Kontaktierung des Treibers 7 auf dem Substrat 2 kann z.B. mit einem anisotropen Kleber erfolgen. Ferner weist der Treiber 7 externe Anschlüsse 9 auf.

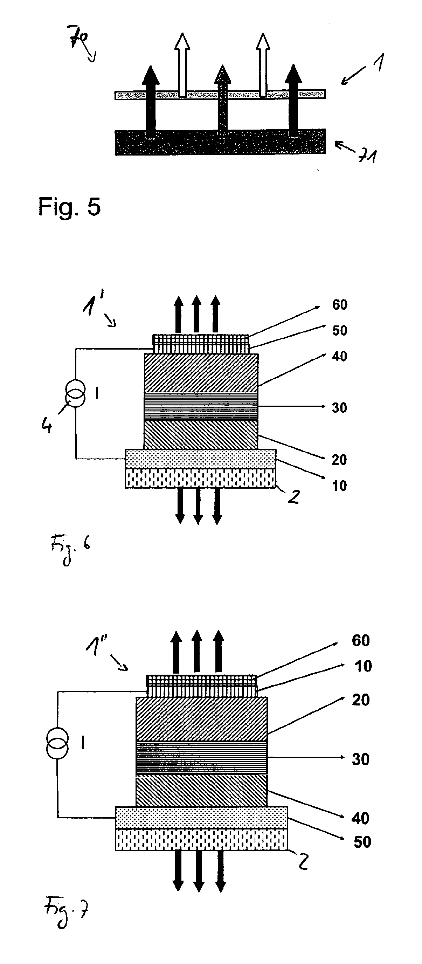

Fig. 5 zeigt ein Beispiel für ein Double-Layer Display, das aus einer transparenten OLED-Anzeige 1 und einem beliebigen anderen Display 71 kombiniert ist, bspw. einem TFT-LCD oder auch einer mechanische Anzeige, Durch das Vorschalten des transparenten Displays 1 wird eine zweite Informationsebene geschaffen. Außerdem lassen sich 3-dimensionale Effekte erreichen.

Je nach Einsatzzweck der transparenten OLED-Anzeige 1 kann es vorteilhaft sein, eine gezielte Auskopplung des emitterten Lichts aus der Anzeige bspw. in oder entgegen der Blickrichtung zu erreichen, wie die nachfolgend erläuterten Beispiele zeigen.

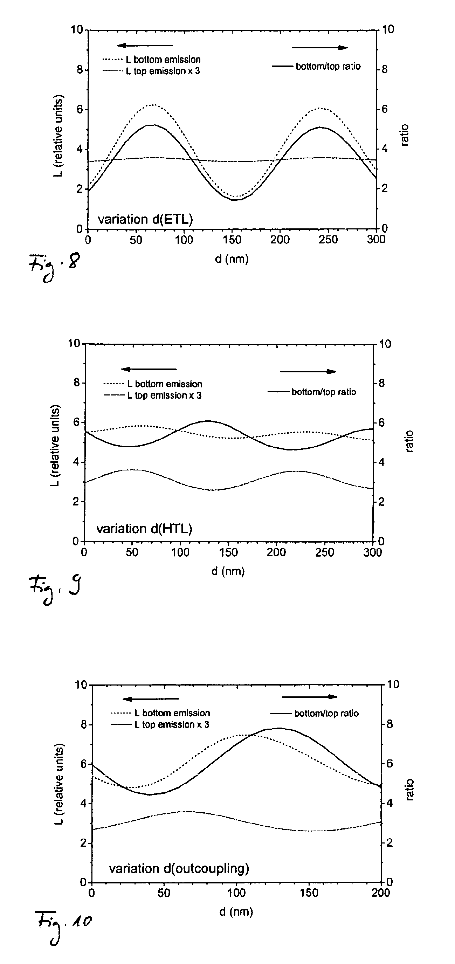

Dazu werden Möglichkeiten für eine gezielte Beeinflussung des Lichtauskoppfungsverhältnisses an der Frontseite (TOP) bzw. der Rückseite (BOTTOM) einer transparenten OLED-Anzeige beschrieben. Dieser Effekt ist nicht auf den zuvor beschriebenen Aufbau einer OLED-Anzeige 1 beschränkt und stellt insoweit auch einen eigenständigen Aspekt der Erfindung dar, der auch bei anders aufgebauten OLED-Anzeigen angewendet werden kann. Ein zu Fig. 1 ähnlicher, typischer Aufbau einer transparenten OLED-Anzeige 1', anhand dessen die gezielte Beeinflussung der Lichtauskopplung beschrieben werden soll, ist in Fig. 6 dargestellt.

Auf einer transparenten Oxidschicht (z.B. Indium-Zinn-Oxid oder Zink-Oxid) als Elektrodenschicht 10, welche auf einem transparentem Substrat 2 angeordnet ist, wird als Hilfsschicht eine Löchertransportschicht 20 aufgebracht, gefolgt von der auch als Emittersystem bezeichneten organischen Emissionsschicht 30, Diese kann wiederum aus mehren Schichten aufgebaut sein, abhängig davon, welche Farbe angestrebt wird. Auf dem Emittersystem 30 wird dann ein Elektronentransportleiter 40 als Hilfsschicht aufgebracht, der durch eine transparente Deckelektrode 50 (Metall bzw. transparente Oxidschichten) abgeschlossen wird. Zusätzlich kann in Sonderformen ein Auskoppelsystem 60 (typischerweise bestehend aus ein bis drei Schichten) aufgebracht werden. In der Anordnung gemäß Fig. 1 bildet die transparente Oxidschicht 10 die Anode und die Deckelektrode 10 die Kathode.

Eine weitere Ausführungsform der OLED-Anzeige 1" zeigt Fig. 7. Hier ist der OLED-Stapel 31 invertiert aufgebaut, d.h. der Elektronentransportleiter 40 befindet sich unterhalb der organischen Emissionsschicht 30. Entsprechend ist die Löchertransportschicht 20 oberhalb der organischen Emissionsschicht 20 angeordnet und Anode 10 und Kathode 50 sind vertauscht. Auch in diesem Fall lässt sich ein transparenter Aufbau einer OLED-Anzeige 1" erreichen, indem die Anode 10 niederohmig angeschlossen wird, obwohl sie nicht unmittelbar auf dem Substrat 2 angeordnet ist, bspw. durch das Einsetzen von Begleitbahnen 11.

Das OLED-System stellt einen optischen Resonator dar, der innerhalb der O-LED-Anzeige 1, 1', 1" die Möglichkeit einer Lichtsteuerung ermöglicht. In einer ersten Ausführungsart dieser Erfindung wird in einer OLED-Anzeige 1, 1', 1" entsprechend des vorher beschriebenen Aufbaus der Elektronentransportleiter 40 in seiner Dicke variiert, so dass weitaus mehr Licht zum transparenten Substrat 2 hin ausgekoppelt wird (Bottom-Richtung) und nur ein kleiner Teil in Richtung der Deckelektrode 50 (Top-Richtung).

In Fig. 8 wird die Dicke des Elektronentransportleiters 40 variiert (d(ETL)). Die OLED-Anzeige 1, 1', 1" besitzt hierbei eine ITO-Schichtdicke der Elektrodenschicht 10 von 90nm, eine Löchertransportschichtdicke 20 von 222 nm und eine Emitterdicke der organischen Emissionsschicht 30 von 20 nm. Wie in der Abbildung dargestellt, kann das Verhältnis zwischen durch das Substrat emittiertern Licht (Bottom) zu dem durch die Deckelektrode emittierte Licht (Top) von ~1.5 bis zu -5 variiert werden (siehe rechte Skala, ratio). Auf der linken Seite ist die Lichtemission L in relativen Einheiten dargestellt. Dies ermöglicht eine gezielte Emissionsvariation innerhalb des Displays durch eine einfache Dickenvariation der Elektronentransportleiterdicke,

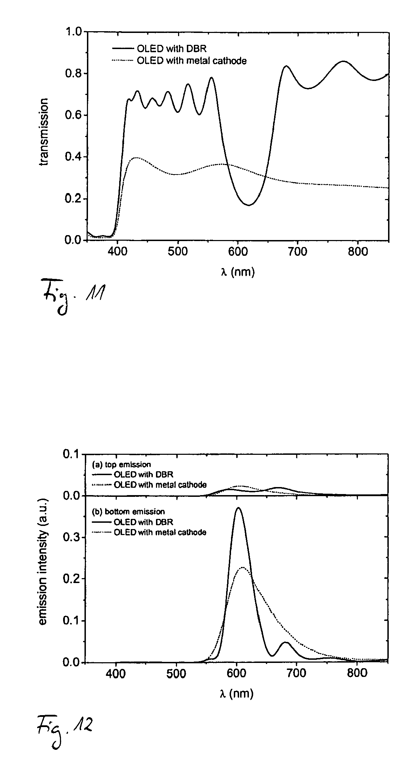

In einer weiteren Ausführungsart wird die Löchertransportschicht 20 variiert (d(HTL)), um eine verschiedene Lichtauskopplung in beide Richtungen zu erreichen. In Fig. 9 wird die Dicke der Löchertransportschicht 20 variert. Die 0-LED-Anzeige 1, 1', 1" besitzt hierbei eine ITO-Schichtdicke der Elektrodenschicht 10 von 90nm, eine Emitterdicke der organischen Emissionsschicht 30 von 20 nm und eine Elektronentransportleiterdicke 40 von 54 nm. Wie in der Abbildung dargestellt, kann das Verhältnis zwischen durch das Substrat emittiertern Licht (Bottom) zu durch die Deckelektrode emittiertern Licht (Top) von ~4,8 bis zu ~6,1 variiert werden.

In einer weiteren Ausführungsform wird das aus Deckelektrode 50 bzw. 10 und Auskoppelschicht 60 aufgebaute System zur Lichtauskoppeloptimierung in Richtung der Deckelelektrode in seiner Dicke variiert.

In Fig. 10 wird die Dicke der Auskoppelschicht 60 variiert, die OLED-Anzeige 1, 1', 1" besitzt hierbei eine ITO-Schichtdicke der Elektrodenschicht 10 von 90nm, eine Löchertransportschichtdicke 20 von 222 nm, eine Emitterdicke der organischen Emissionsschicht 30 von 20 nm, eine Elektronentransportleiterdicke 40 von 54 nm und eine Elektrodendicke der transparenten Kathode 50 von 20 nm. Wie in der Abbildung dargestellt, kann das Verhältnis zwischen durch das Substrat emittierte Licht (Bottom) und durch die Deckelektrode emittierte Licht (Top) von ~4,4 bis zu ~7,8 variiert werden.

In einer Anwendungsform wird dieser Effekt genutzt, um für ein transparentes Display eine bevorzugte Lichtauskopplungsrichtung zu erreichen. Diese Anwendungsform ist insbesondere dann anzuwenden, wenn ein transparentes Display (OLED-Anzeige 1, 1', 1 ") nur in einer Richtung gut lesbar zu halten ist, ohne die Transparenz zu beeinflussen.

In einer weiteren Ausführungsform des Auskoppelsystems 60 wird für den Fall einer (im wesentlichen) monochromen OLED-Anzeige 1, 1', 1" insbesondere die Kombination der beiden Anforderungen (i) Emission möglichst nur in eine Richtung (einen Halbraum) und (ii) möglichst hohe Transparenz der OLED-Anzeige 1,1', 1" realisiert. Dazu wird die transparente Deckelektrode 50 in Fig. 6 zunächst auf maximale Transparenz im gesamten sichtbaren Spektralbereich hin optimiert. Dafür bieten sich insbesondere transparente leitfähige Oxide (z.B. Indium-Zinn-Oxid) an. Ohne Auskoppelsystem 60 liegt damit eine hochtransparente OLED-Anzeige 1, 1', 1" vor, die jedoch sowohl in Richtung des Substrats ("bottom") als auch in Richtung der Deckelektrode ("top") mit Leuchtdichten gleicher Größenordnung emittiert.

Der OLED-Stapel 31, ggf. einschließlich der Elektroden 10, 50 oder das Auskoppelsystem 60 gemäß Fig. 6, 7 kann auch als wellenlängenselektiver dielektrischer Spiegel ("distributed Bragg reflector", DBR) gestaltet werden, wie nachfolgend am Beispiel des Auskoppelsystems 60 erläutert. Der wellenlängenselektive dielektrische Spiegel wird dafür als schmalbandiger Hoch-Reflektor (entspricht einem Bandpass-Sperrfilter) dimensioniert, d.h. er ist möglichst hoch reflektierend im schmalen Wellenlängenbereich der OLED-Emission und möglichst transparent im restlichen Spektralbereich. Damit wirkt der wellenlängenselektiver dielektrischer Spiegel für die OLED-Emission im Idealfall als idealer Spiegel und die Emission erfolgt ausschließlich in Richtung des Substrats (bottom-Emission), wobei die Effizienz durch Ausnutzung des ansonsten in top-Richtung emittierten Lichts etwa auf das Doppelte der Effizienz bei reintransparenter Deckelektrode steigt. Da der wellenlängenselektive dielektrische Spiegel im Gegensatz zu einem metallischen Reflektor außer in seinem schmalen Sperrband transparent ist, erscheint auch die OLED-Anzeige 1, 1', 1" als Ganzes nahezu transparent.

Der wellenlängenselektive dielektrische Spiegel kann durch geeignete Schichtkombinationen aus rein anorganischen, rein organischen oder auch organisch/ anorganischen Schichten hergestellt werden. Da für einen schmalbandigen Reflektor nur ein geringer Brechungsindexkontrast nötig ist, bestehen große Freiheiten in der Auswahl der Materialien. Die Breite des Sperrbandes eines dielektrischen Spiegels beträgt genähert

$$\frac{\Delta\lambda}{\lambda} = \frac{4}{\pi} \cdot \frac{n_H - n_L}{n_H + n_L},$$

wobei $\lambda$ die Wellenlänge, $n_H$ der Brechungsindex des höher-brechenden Materials und $n_L$ der Brechungsindex des nieder-brechenden Materials ist.

Um z.B. eine Sperrbandbreite von ca. 50 nm bei 612 nm (rot-oranger Emitter) zu erreichen, können zum Beispiel Materialien mit $n_H$=1.7 und $n_L$=1.5 eingesetzt werden. $n_H$=1.7 ist ein typischer Wert für viele organische Materialien, zum Beispiel den in Fig. 9 betrachteten Löchtertransporter. $n_L$=1.5 ist ein typischer Wert für das weit eingesetzte Siliziumdioxid, aber auch für einige organische Materialien bei geeigneten Wellenlängen (zum Beispiel annähernd erreicht vom in Fig. 8 betrachteten Elektronentransporter).

Der Einsatz von rein-organischen Schichten für den wellenlängenselektiver dielektrischer Spiegel ist besonders vorteilhaft, da erstens keine zusätzlichen Beschichtungsquellen erforderlich sind und zweitens durch die geringen Prozesstemperaturen wenig thermischer Stress für die die OLED-Anzeige 1', 1" entsteht und vor allem auch das typische Verspannungsproblem bei anorganischen Schichten stark reduziert wird.

Als Beispiel wird ein wellenlängenselektiver dielektrischer Spiegel aus zehn Paaren von Lambda-Viertel-Schichten betrachtet. Als High-Index Schicht wird dabei das organische Material des Löchtertransporters 20 eingesetzt (vereinfachte Annahmen: konstanter Brechungsindex $n_H$=1.7, Absorption Null). Als Low-Index-Material wird Siliziumdioxid oder der Elektronentransporter 40 betrachtet (vereinfachte Annahmen: konstanter Brechungsindex $n_L$=1.5, Absorption Null). Die Deckelektrode 50 gemäß Fig. 6 wird als ITO-Schicht betrachtet und in der Dicke so optimiert, dass die Leuchtdichte in Bottom-Richtung maximal wird (im Beispiel Dicke=106 nm). Im Sinne des wellenlängenselektiven dielektrischen Spiegels ist diese ITO-Schicht bereits die erste High-Index-Schicht. Danach schließen sich im Auskoppelsystem 60 die erste Low-Index-Schicht (Dicke=102 nm), die erste High-Index-Schicht (Dicke=90 nm) und so fort an. Den Abschluss bildet die zehnte High-Index-Schicht.

Dieses System wird in Fig. 11 und 12 mit einer OLED ohne Auskoppelsystem und semitransparenter Metall-Deckelektrode (40 nm Ytterbium) verglichen. Fig. 11 zeigt die berechnete spektrale Transmission einer OLED-Anzeige 1' mit transparenter oxidischer Kathode und Bragg-Reflektor (DBR) als Auskoppelsystem 60 im Vergleich zu einer OLED mit dünner, semitransparenter Metallkathode ohne Auskoppelsystem. Klar ist erkennbar, dass die Transparenz der erfindungsgemäßen OLED-Anzeige 1' mit wellenlängenselektivem dielektrischen Spiegel (DBR) als Auskoppelsystem 60 nahezu im gesamten Spektralbereich etwa doppelt so hoch ist wie im Fall der lediglich semitransparenten Metallkathode. Nur in dem etwa 80 nm breiten Sperrband des wellenlängenselektiven dielektrischen Spiegels um die Design-Wellenlänge 612 nm ist die Transparenz deutlich geringer, da dort das Emissionslicht der organische Emissionsschicht 30 reflektiert werden soll.

Fig. 12 zeigt die Spektren des emittierten Lichts in Bottom- und Top-Richtung als berechnete spektrale Emission einer OLED-Anzeige 1' mit transparenter oxidischer Kathode und Bragg-Reflektor (DBR) als Auskoppelsystem 60 im Vergleich zu einer OLED mit dünner, semitransparenter Metallkathode ohne Auskoppelsystem, wobei (a) die senkrechte Emission in Richtung der Kathode 50 (top-Richtung) und (b) die senkrechte Emission in Substratrichtung (bottom-Richtung) in gleicher Skalierung wie für (a) zeigt. Hier verhalten sich beide Anzeigen ähnlich, da bei der Emissionswellenlänge der wellenlängenselektive dielektrische Spiegel ähnlich wie die Ytterbiumelektrode wirkt. Die Gesamtleuchtdichte in Bottom-Richtung ist mit 9.2 relativen Einheiten gegenüber 7.6 relativen Einheiten bei der OLED mit Metallkathode sogar geringfügig verbessert. Das Verhältnis bottom- zu top-Emission ist für die OLED-Anzeige mit wellenlängenselektivem dielektrischen Spiegel mit 12.8 gegenüber 9.1 bei der OLED mit Metallkathode deutlich verbessert.

Durch entsprechend aufwändiges Design des wellenlängenselektiven dielektrischen Spiegels sind die Paramter, insbesondere Transparenz der OLED-Anzeige 1, 1', 1" außerhalb des Emissionsgebietes und die Unterdrückung der Top-Emission prinzipiell beliebig gut einstellbar. Damit kann prinzipiell ein monochromes Display beliebig gut angenähert werden, das bis auf ein sehr schmales Emissions- und Sperrband nahezu vollständig transparent ist und das nur in eine Richtung emittiert.

Mit der Erindung wird ein Aufbau für eine transparente OLED-Anzeige 1, 1' 1" mit transparenten Ansteuerelektroden (Anoden 10, Kathoden 50) mit vorzugsweise selektiver und teilselektiver Emissionsrichtung beschrieben. Zwischen den Elektroden 10, 50 befinden sich eine oder mehrere Schichten 20, 30, 40, von denen mindestens eine eine organische Emissionsschicht 30 ist. Diese Schichten sind auf einem transparenten Substrat 2 angeordnet. Für die Ansteuerung einer derartigen Anzeige sind die Anoden 10 sehr niederohmig ausgeführt, so dass diese bei einer Ansteuerung im Multiplexbetrieb als Scanelektrode dienen können. Die Kathoden 50 sind dagegen als Datensignale erhaltende Gegenelektroden ausgeführt.

## Bezugszeichenliste

| | |
|---|---|
| 1,1',1" | OLED-Anzeige |
| 2 | transparentes Substrat |
| 3 | transparente Einkapselung |
| 4 | Stromquelle |
| 5 | transparente Anode auf dem Substrat, Spaltenelektrode |
| 6 | nicht transparente Kathode, Zeilenelektrode |
| 7 | Treiber |
| 8 | metallische Zuleitungen |
| 9 | externe Anschlüsse |
| 10 | Elektrodenschicht, Anode |
| 11 | Begleitbahn |
| 12 | Anoden-Linie |
| 20 | organische Hilfsschicht, Löchertransportschicht |
| 30 | organische Emissionsschicht |
| 31 | OLED-Stapel |
| 40 | organische Hilfsschicht, Elektronentransportleiter |
| 50 | Elektrodenschicht, Kathode |
| 60 | Hilfsschicht, Auskoppelsystem |
| 70 | Double-Layer Display |
| 71 | anderes Display |

## Patentansprüche

1. OLED-Anzeige mit oberen und unteren Elektroden (10, 50), zwischen denen eine oder mehrere Schichten angeordnet sind, von denen mindestens eine eine organische Emissionsschicht (30) ist, und mit einem transparenten Substrat (2), **dadurch gekennzeichnet, dass** bei Multiplexansteuerung die gescannten Elektroden als Anode (10) ausgeführt sind und aus einem transparenten Material bestehen und dass die Datensignale erhaltenden Gegenelektroden als transparente Kathoden (50) ausgeführt sind.

2. OLED-Anzeige nach Anspruch 1, **dadurch gekennzeichnet, dass** die Elektroden der Anode (10) mit einer niederohmigen Begleitbahn (11) versehen sind.

3. OLED-Anzeige nach Anspruch 2, **dadurch gekennzeichnet, dass** die niederohmige Begleitbahn (11) aus einer dünnen Metallschicht bestehen.

4. OLED-Anzeige nach Anspruch 3, **dadurch gekennzeichnet, dass** die Metallschicht aus Kupfer oder Messing aufgebaut ist.

**5.** OLED-Anzeige nach einem der vorhergehenden Ansprüche, **dadurch gekennzeichnet, dass** die Elektroden der transparenten Kathode (50) aus einer oder mehreren dünnen Metallschicht(en) aufgebaut sind.

**6.** OLIwD-Anzeige nach einem der Ansprüche 1 bis 4, **dadurch gekennzeichnet, dass** die Elektroden der transparenten Kathode (50) aus einem transparenten anorganischen Leiter zusammen mit einer organischen oder anorganischen, n-dotierten Hilfsschicht aufgebaut sind.

**7.** OLED-Anzeige nach einem der vorhergehenden Ansprüche, **dadurch gekennzeichnet, dass** eine oder mehrere der Schichten als organische und/oder anorganische Hilfsschichten (20, 40) ausgebildet sind, welche vorzugsweise auf beiden Seiten der organischen Emissionsschicht (30) angeordnet sind.

**8.** OLED-Anzeige nach einem der vorhergehenden Ansprüche, **dadurch gekennzeichnet, dass** auf einer einem transparentem Substrat gegenüberliegenden Seite der OLED-Anzeige angeordneten Elektrode (50) ein eine oder mehrere Hilfsschicht(en) aufweisendes Auskoppelsystem (60) vorgesehen ist.

**9.** OLED-Anzeige nach einem der Ansprüche 7 oder 8, **dadurch gekennzeichnet, dass** mindestens eine Hilfsschicht (20, 40, 60) bezüglich ihrer Dicke und/oder ihres Brechungsindex derart ausgewählt wird, dass die Emission des Lichtes der OLED-Anzeige (1, 1', 1'') teilweise oder vollständig nur zu einer Seite der OLED-Anzeige (1,1', 1 '') hin erfolgt.

**10.** OLED-Anzeige nach Anspruch 8 und 9, **dadurch gekennzeichnet, dass** das Auskoppelsystem (60) und/oder eine oder mehrere Hilfsschicht(en) (20, 40) sowie ggf. die organische Emissionsschicht (30) als wellenlängenselektiver dielektrischer Spiegel ausgebildet sind, vorzugsweise als schmalbandiger Hoch-Reflektor.

**11.** OLED-Anzeige nach einem der vorhergehenden Ansprüche, **gekennzeichnet durch** eine niederohmige Schaltung auf dem transparenten Substrat (2) der OLED-Anzeige (1,1', 1'') zur direkten Kontaktierung eines oder mehrerer Treiber(s) (7) **durch** anisotrope Kontaktmedien sowie zur niederohmigen Anbindung der Zeilen- und Spaltenelektroden (10, 50).

**12.** OLED-Anzeige nach einem der vorhergehenden Ansprüche, **dadurch gekennzeichnet, dass** ein Treiberbaustein (7) mit einer Funktion zum Scannen von Anoden (10) unter hoher Strombelastung und zur Lieferung von Datensignalen für die Kathoden (50) vorgesehen ist.

**13.** OLED-Anzeige nach einem der vorhergehenden Ansprüche, **dadurch gekennzeichnet, dass** die OLED-Anzeige (1) als zusätzliches Display auf mindestens einem anderen Display (71) angeordnet ist.

**14.** Verwendung einer oder mehrerer OLED-Anzeigen (1, 1', 1'') nach einem der vorhergehenden Ansprüche in Kombination mit einem Display (71) beliebiger Technologie zur Ermöglichung einer vorgelagerten transparenten Informationsebene und/oder zur Erzielung eines 3-dimensionalen Bildeffektes.

Fig. 1

Fig. 2

Strom I

Fig. 3

Strom I

Fig. 4

EP 1 903 610 A2

Fig. 5

Fig. 6

Fig. 7

**Fig. 8**

**Fig. 9**

**Fig. 10**

Fig. 11

Fig. 12